(19) Europäisches Patentamt
European Patent Office
Office européen des brevets

(11) **EP 1 947 766 A2**

(12) **EUROPÄISCHE PATENTANMELDUNG**

(43) Veröffentlichungstag:
**23.07.2008 Patentblatt 2008/30**

(51) Int Cl.:
***H03K 7/08*** *(2006.01)*

(21) Anmeldenummer: 07120536.3

(22) Anmeldetag: **13.11.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK RS**

(30) Priorität: **09.01.2007  DE 102007001389**

(71) Anmelder: **SIEMENS AKTIENGESELLSCHAFT
80333 München (DE)**

(72) Erfinder:
• **Krause, Uwe
30982, Pattensen (DE)**
• **Nolte, Uwe
30890, Barsinghausen (DE)**
• **Spannberger, Jan
30171, Hannover (DE)**

(54) **Verfahren und Vorrichtung zur Pulsweitenmodulation**

(57)   Die Erfindung betrifft ein Verfahren und eine Vorrichtung zur Pulsweitenmodulation mit einer vorgegebenen Schaltperiode (Ts) mit einem einstellbaren Verhältnis von Einschaltdauer (Te) und Ausschaltdauer (Ta), bei welchem ein quantisiertes Signal (A) in ein pulsweitenmoduliertes Signal (PWM) umgesetzt und als eine diskrete Impulsfolge von Einschaltvorgängen und Ausschaltvorgängen mit der vorgegebenen Schaltperiode (Ts) erzeugt wird, wobei die Schaltflanke für die Einschaltdauer (Te) und/oder die Ausschaltdauer (Ta) in Abhängigkeit vom Verhältnis von Einschaltdauer (Te) und Ausschaltdauer (Ta) bestimmt wird.

FIG 1
( Stand der Technik )

FIG 2

FIG 3

EP 1 947 766 A2

**Beschreibung**

Die vorliegende Erfindung bezieht sich auf ein Verfahren und eine Vorrichtung zur Pulsweitenmodulation, bei welchem ein quantisiertes Signal in ein pulsweitenmoduliertes Signal umgesetzt wird.

Das Verfahren wird insbesondere in der Leistungselektronik beim Betrieb von elektrischen Maschinen, z.B. einer Drehstrommaschine oder eines Wechselrichters, eingesetzt. Diesen elektrischen Maschinen ist gleich, dass beispielsweise eine erzeugte elektrische Wechselspannung gemittelt über die Dauer einer Schaltperiode (auch Schaltzyklus genannt) einem vorgegebenen Sollwert folgt. Hierbei wird die Pulsweitenmodulation zur Umrechnung des Sollwerts in ein pulsweitenmoduliertes Rechtecksignal verwendet, das eine entsprechende binäre Schaltbefehlsfolge oder diskrete Impulsfolge von Einschaltvorgängen und Ausschaltvorgängen umfasst.

Dabei kann es durch die ermittelte Schaltbefehlsfolge, insbesondere durch die Einschaltvorgänge zu Störungen in diesem Zeitraum kommen, welche beispielsweise die Erfassung von elektrischen und nichtelektrischen Messgrößen beeinflussen. Eine weitgehend fehlerfreie Messung von elektrischen und nichtelektrischen Messgrößen ist aufgrund des veränderbaren Tastverhältnisses von Einschaltdauer und Ausschaltdauer der Einschaltvorgänge bzw. Ausschaltvorgänge ohne Einschränkung des Aussteuerbereichs nur mit erhöhtem Aufwand möglich.

Der Erfindung liegt daher die Aufgabe zugrunde, ein Verfahren und eine Vorrichtung zur Pulsweitenmodulation anzugeben, bei welchem eine Messwerterfassung weitgehend störungsfrei ermöglicht ist, ohne den Aussteuerbereich einzuschränken.

Hinsichtlich des Verfahrens wird die Aufgabe erfindungsgemäß gelöst durch die Merkmale des Anspruchs 1 und hinsichtlich der Vorrichtung durch die Merkmale des Anspruchs 11.

Vorteilhafte Weiterbildungen der Erfindung sind Gegenstand der Unteransprüche.

Beim erfindungsgemäßen Verfahren zur Pulsweitenmodulation mit einer vorgegebenen Schaltperiode mit einem einstellbaren Tastverhältnis von Einschaltdauer und Ausschaltdauer wird ein quantisiertes Signal in ein pulsweitenmodulierten Signal umgesetzt und als eine diskrete Impulsfolge von Einschaltvorgängen und Ausschaltvorgängen mit der vorgegebenen Schaltperiode erzeugt, wobei die Schaltflanke für die Einschaltdauer und/oder die Ausschaltdauer in Abhängigkeit vom Tastverhältnis von Einschaltdauer und Ausschaltdauer bestimmt wird. Durch die Ermittlung der Schaltflanke/n für die Einschaltdauer und/oder die Ausschaltdauer in Abhängigkeit vom ermittelten Tastverhältnis von Einschaltdauer zu Ausschaltdauer umfasst die daraus resultierende Impulsfolge von Ein- und Ausschaltvorgängen Zeitspannen, die sicher schaltfrei sind. Darüber hinaus treten diese schaltfreien Zeitspannen bevorzugt innerhalb der Schaltperiode stets zum gleichen Zeitpunkt auf. Somit können innerhalb der Schaltperiode in diesen sicher schaltfreien Zeitspannen Messwerte störungsfrei erfasst werden.

In einer möglichen Ausführungsform wird die Schaltflanke der Einschaltdauer bei einem Tastverhältnis von Einschaltdauer zur Ausschaltdauer von kleiner 1 am Anfang der Schaltperiode gesetzt. Mit anderen Worten ist die Einschaltdauer kleiner als die Ausschaltdauer, so wird die Schaltflanke der Einschaltdauer am Anfang der Schaltperiode gesetzt. Alternativ oder zusätzlich kann die Schaltflanke der Ausschaltdauer bei einem Tastverhältnis von Einschaltdauer zur Ausschaltdauer von kleiner 1 am Ende der Schaltperiode gesetzt werden.

In einer weiteren Ausführungsform kann bei einem Tastverhältnis von Einschaltdauer zur Ausschaltdauer von größer 1 die Schaltflanke der Einschaltdauer am Ende der Schaltperiode und/oder die Schaltflanke der Ausschaltdauer am Anfang der Schaltperiode gesetzt werden. Ist beispielsweise die Einschaltdauer größer als die Ausschaltdauer, so werden oder wird die Schaltflanke der Einschaltdauer am Anfang und/oder die Schaltflanke der Ausschaltdauer am Ende gesetzt.

Alternativ oder zusätzlich kann die Zeitdauer der Einschaltdauer durch die Zeitdauer der Ausschaltdauer ersetzt werden. Auch kann alternativ oder zusätzlich die Zeitdauer der Ausschaltdauer durch die Zeitdauer der Einschaltdauer ersetzt werden.

In einer weiteren alternativen Ausführungsform kann die Schaltflanke für die Einschaltdauer und/oder die Ausschaltdauer bevorzugt durch Negation des binären Ausgangs und gleichzeitiger Vertauschung der innerhalb der Schaltperiode erzeugten Ausschaltvorgänge bzw. Einschaltvorgänge bestimmt werden.

Bei einer symmetrischen Pulsweitenmodulation werden innerhalb der Schaltperiode vorzugsweise mindestens zwei Einschaltdauern vorgegeben, deren Schaltflanken am Anfang und am Ende der Schaltperiode gesetzt werden. Hierdurch ist insbesondere die Mitte der Schaltperiode frei von Schaltzeitpunkten, so dass eine störungs- und gegebenenfalls fehlerfreie Messwerterfassung durchgeführt werden kann. Hierbei wird zweckmäßigerweise ein der symmetrischen Pulsweitenmodulation zugrunde liegendes Referenzsignal als ein vom Anfang der Schaltperiode bis zur Mitte der Schaltperiode fallendes und von der Mitte bis zum Ende der Schaltperiode steigendes Signal vorgegeben. In einer bevorzugten Ausführungsform wird als Referenzsignal ein Zählersignal verwendet.

Hinsichtlich der Vorrichtung zur Pulsweitenmodulation umfasst diese eine Steuereinheit, die derart ausgebildet ist, dass diese ein quantisiertes Signal in ein pulsweitenmoduliertes Signal umsetzt und dieses als eine diskrete Impulsfolge von Einschaltvorgängen und Ausschaltvorgängen mit der vorgegebenen Schaltperiode erzeugt, wobei die Schaltflanke für die Einschaltzeit in Abhängigkeit vom Tastverhältnis von Einschaltdauer und Ausschaltdauer bestimmbar ist. Die Steuereinheit umfasst dabei je nach Art und Weise der Bestimmung der Schaltflanken von Einschaltdauer und/oder Ausschaltdauer geeignete Komponenten, beispielsweise Signalgeneratoren, Komparatoren, Negationsmittel und/oder Zähler.

Die mit der Erfindung erzielten Vorteile bestehen insbesondere darin, dass durch die Verschiebung der Schaltflanken von Einschaltdauer und/oder Ausschaltdauer innerhalb der vorgegebenen Schaltperiode Zeitspannen ermöglicht sind, die sicher frei von Schaltzeitpunkten gehalten sind. Insbesondere ist dies über die gesamte Schaltperiode für mindestens 50 % der Periode möglich. Hierdurch können beispielsweise bei beliebigen Systemen und Geräten mit Pulsweitenmodulation innerhalb der schaltfreien Zeitspannen elektrische und nicht elektrische Messgrößen weitgehend störungsfrei erfasst werden, d.h. ohne das Störungen durch Schaltvorgänge auftreten. Darüber hinaus können die Messwerterfassungen stets zum gleichen Zeitpunkt innerhalb der Schaltperiode der Pulsweitenmodulation erfolgen und somit synchron.

Ausführungsbeispiele der Erfindung werden anhand einer Zeichnung näher erläutert. Darin zeigen:

FIG 1      ein Zeitdiagram einer diskreten Folge von Ein- und Ausschaltvorgängen eines pulsweitenmodulierten Signals im Stand der Technik,

FIG 2      ein Zeitdiagramm einer diskreten Folge von Ein- und Ausschaltvorgängen eines pulsweitenmodulierten Signals mit Verschiebung der Schaltflanke der Einschaltdauer zum Anfang der Schaltperiode,

FIG 3      ein Zeitdiagramm einer diskreten Folge von Ein- und Ausschaltvorgängen eines pulsweitenmodulierten Signals mit Verschiebung der Schaltflanke der Einschaltdauer zum Ende der Schaltperiode,

FIG 4A bis 4C      mehrere Zeitdiagramme einer diskreten Folge von Ein- und Ausschaltvorgängen eines pulsweitenmodulierten Signals mit Verschiebung der Schaltflanke der Einschaltdauer und/oder Ausschaltdauer durch Negation der Ausschaltdauer bzw. Einschaltdauer,

FIG 5A bis 5B      mehrere Zeitdiagramme einer diskreten Folge von Ein- und Ausschaltvorgängen eines pulsweitenmodulierten Signals bei einer symmetrischen Pulsweitenmodulation mit Verschiebung der Schaltflanken zweier Einschaltdauern an den Anfang und das Ende der Schaltperiode, und

FIG 6      schematisch eine Ausführungsform für eine Vorrichtung zur Pulsweitenmodulation mit einer Steuereinheit.

Einander entsprechende Teile und Funktionen sind in allen Zeichnungen mit den gleichen Bezugszeichen versehen.

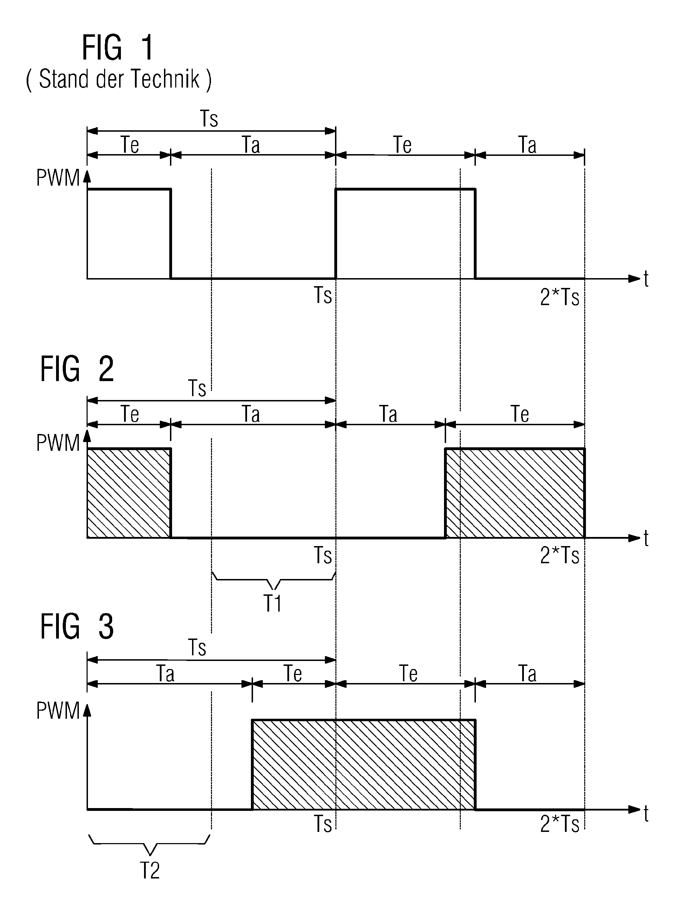

Figur 1 zeigt ein Zeitdiagram einer diskreten Folge von Einschaltvorgängen mit einer Einschaltdauer Te und Ausschaltvorgängen mit einer Ausschaltdauer Ta eines pulsweitenmodulierten Signals PWM im Stand der Technik. Das dem Zeitdiagramm zugrunde liegende Pulsweitmodulationsverfahren weist eine vorgegebene Schaltperiode Ts auf. Dabei wird mittels der Pulsweitenmodulation innerhalb der Schaltperiode TS die Folge von Einschaltvorgängen und Ausschaltvorgängen mit einem veränderbaren Verhältnis von Einschaltdauer Te und Ausschaltdauer Ta erzeugt. Ein derartiges herkömmliches Pulsweitenmodulationsverfahren wird beispielsweise in der Leistungselektronik zur Ansteuerung von elektrischen Maschinen oder Geräten und Systemen der Unterhaltungselektronik eingesetzt.

Für eine von den Schaltvorgängen des Pulsweitenmodulationsverfahrens weitgehend freie Erfassung von elektrischen und nicht elektrischen Messgrößen an der zu steuernden Einrichtung, z.B. einem Gleichstromsteller, wird beim erfindungsgemäßen Verfahren die Schaltflanke für die Einschaltdauer Te und/oder die Ausschaltdauer Ta in Abhängigkeit vom Verhältnis von Einschaltdauer Te zu Ausschaltdauer Ta bestimmt. Dabei wird die jeweils bestimmte Schaltflanke innerhalb der vorgegebenen Schaltperiode Ts verschoben. In den nachfolgenden Figuren 2 und 3 sind verschiedene Ausführungsbeispiele gezeigt.

Figur 2 zeigt ein Zeitdiagramm einer diskreten Folge von Einschaltvorgängen und Ausschaltvorgängen eines pulsweitenmodulierten Signals PWM mit einer Verschiebung der Einschaltflanke der Einschaltdauer Te zum Anfang der Schaltperiode Ts der ersten Periode Ts und einer Verschiebung der Ausschaltflanke der Einschaltdauer Te zum Ende der Schaltperiode Ts in der zweiten Periode 2*Ts. Dabei wird die Verschiebung wie folgt bestimmt. Ist die Einschaltdauer Te kleiner als die Ausschaltdauer Ta und liegt somit ein Verhältnis kleiner 1 vor (siehe Periode Ts), so wird die Einschaltflanke der Einschaltdauer Te an den Anfang der Schaltperiode Ts verschoben. Ist die Einschaltdauer Te größer als die Ausschaltdauer Ta und liegt somit ein Verhältnis größer 1 vor, so wird die Schaltflanke für Ausschaltdauer Ta an den Anfang der Schaltperiode Ts verschoben werden (siehe Periode 2*Ts). Hierdurch ist, wie in Figur 2 gezeigt, die Zeitspanne T1 und somit die zweite Hälfte der Schaltperiode Ts der ersten Periode Ts frei von Schaltzeitpunkten.

Figur 3 zeigt eine alternative Ausführungsform. Dabei zeigt das Zeitdiagramm eine diskrete Folge von Ein- und Ausschaltvorgängen eines pulsweitenmodulierten Signals PWM mit Verschiebung der Schaltflanke der Einschaltdauer Te zum Ende der Schaltperiode Ts in der ersten Periode Ts und einer Verschiebung der Ausschaltdauer Ta zum Ende der Schaltperiode Ts in der zweiten Periode 2*Ts. Dabei wird die Verschiebung wie folgt bestimmt. Ist die Einschaltdauer Te kleiner als die Ausschaltdauer Ta und liegt somit ein Verhältnis kleiner 1 vor (siehe Periode Ts), so wird die Schaltflanke der Einschaltdauer Te an das Ende der Schaltperiode Ts verschoben. Ist die Einschaltdauer Te größer als die Ausschaltdauer Ta und liegt somit ein Verhältnis größer 1 vor, so wird die Schaltflanke für die Ausschaltdauer Ta an das Ende der Schaltperiode Ts verschoben werden (siehe Periode 2*Ts). Hierdurch ist, wie in Figur 3 gezeigt, die Zeitspanne T2 und somit die erste Hälfte der Schaltperiode Ts der ersten Periode Ts frei von Schaltzeitpunkten.

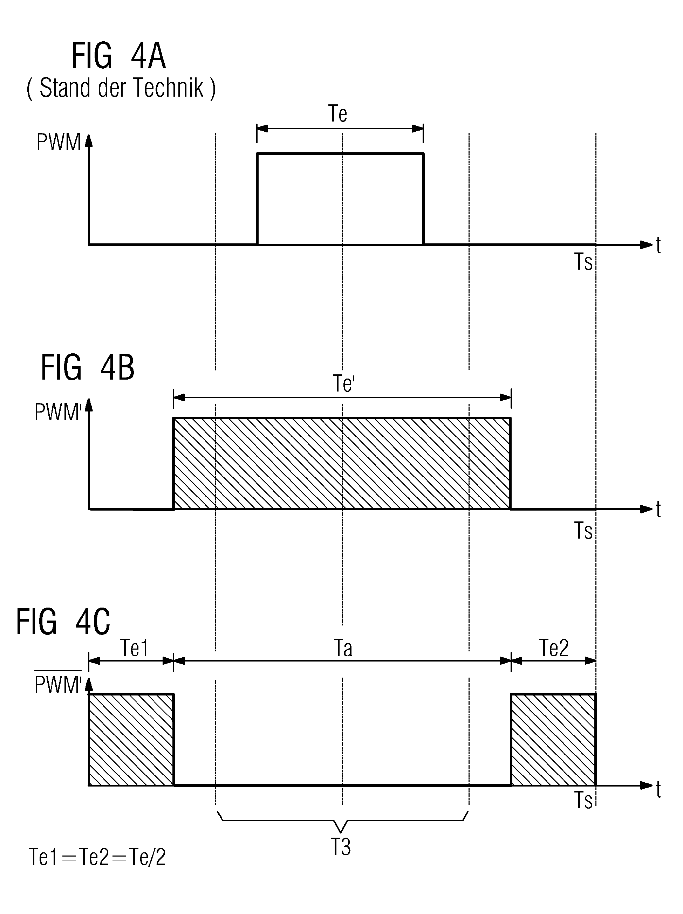

Die Figuren 4A bis 4C zeigen ein weiteres Ausführungsbeispiel für das geänderte Pulsmodulationsverfahren mit verschobenen Schaltflanken für die Ein- und Ausschaltvorgänge durch doppelte Negierung. Dabei zeigt die Figur 4A ein Zeitdiagramm mit dem herkömmlichen pulsweitenmodulierten Signal PWM. Figur 4B zeigt ein aus einer ersten Negierung resultierendes, pulsweitenmoduliertes Signal PWM' derart, dass durch Setzen des Pulsweitenmodulationsregisters das erste negierte pulsweitenmodulierte Signal PWM' wie folgt gebildet wird:

$$PWM' = 100\% - PWM.$$

Hieraus ergibt sich eine gegenüber der Einschaltdauer Te des ursprünglichen Signals PWM verlängerte Einschaltdauer Te' des ersten negierten Signals PWM'. Figur 4C zeigt das durch logische Negation des ersten negierten, pulsweitenmodulierten Signals PWM' erzeugte zweite negierte pulsweitenmodulierte Signal $\overline{PWM}$, das zum Beispiel durch Negierung der Spannungszeitfläche des ersten negierten Signals PWM' erzeugt wird. Daraus resultierend werden im in den Figuren 4B und 4C gezeigten Ausführungsbeispiel zwei Einschaltdauern Te1 und Te2 ermittelt, deren Einschaltflanke bzw. Ausschaltflanke an den Anfang bzw. das Ende der Schaltperiode Ts verschoben werden. Hierdurch ist im mittleren Bereich der Schaltperiode Ts eine Zeitspanne T3 frei von Schaltzeitpunkten.

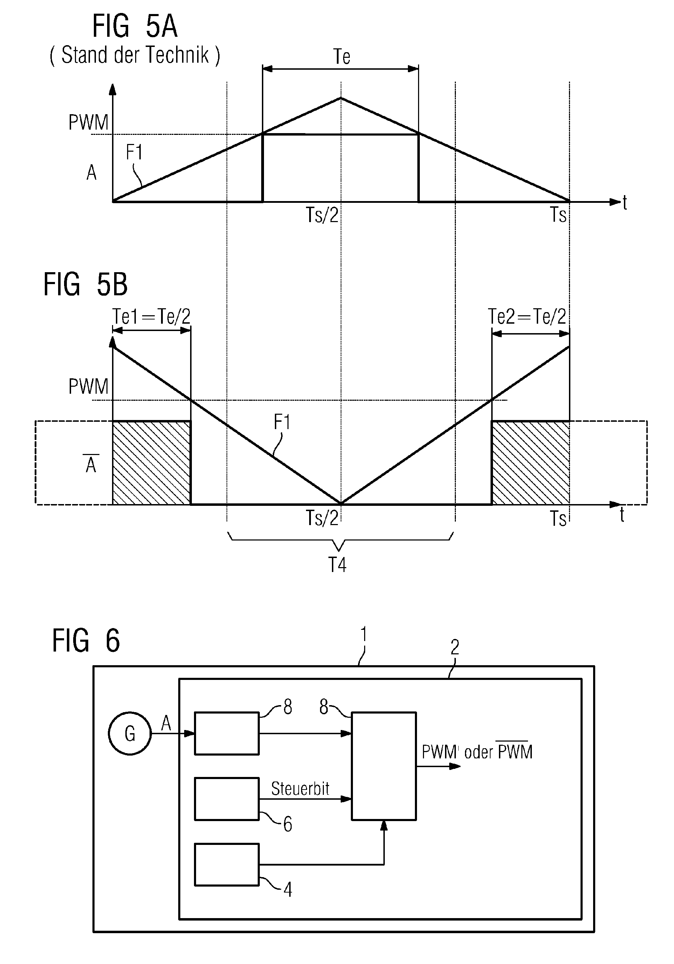

Figuren 5A bis 5B zeigen mehrere Zeitdiagramme einer diskreten Folge von Ein- und Ausschaltvorgängen eines pulsweitenmodulierten Signals PWM bei einer symmetrischen Pulsweitenmodulation mit Verschiebung der Schaltflanken zweier Einschaltdauer Te an den Anfang und das Ende der Schaltperiode Ts. Dabei werden die Schaltflanken, insbesondere die Einschaltflanke der Einschaltdauer Te1 und die Ausschaltflanke der Einschaltdauer Te2 derart verschoben, dass die Einschaltflanke der Einschaltdauer Te1 am Anfang und die Ausschaltflanke der Einschaltdauer Te2 am Ende Schaltperiode Ts und somit voneinander beabstandet angeordnet sind. Hierdurch ist sichergestellt, dass eine mittig in der Schaltperiode Ts angeordnete Zeitspanne T4 frei von Schaltzeitpunkten ist. Zur Verschiebung der Schaltflanken der Einschaltdauern Te1 und Te2 umfasst eine Vorrichtung 1 zur Pulsweitenmodulation, wie sie beispielhaft in Figur 6 dargestellt ist, eine Steuereinheit 2, die einen Zählerbaustein 4 mit einer Zählfunktion F1 aufweist, die anstelle des herkömmlichen Aufwärts- und anschließenden Abwärtszählens umgekehrt erst abwärts und dann aufwärts zählt.

In Figur 6 kann die Vorrichtung 1 zur Pulsweitenmodulation darüber hinaus für die anderen oben beschriebenen Ausführungsbeispiele entsprechende Komponenten, wie z.B. einen Signalgenerator G, einen Komparator 6 und ein Negationsmittel 8, z.B. ein XOR-Glied, umfassen. Die Vorrichtung 1 ist beispielsweise ein Mikroprozessor oder eine andere geeignete Datenverarbeitungseinheit.

**Patentansprüche**

1.  Verfahren zur Pulsweitenmodulation mit einer vorgegebenen Schaltperiode (Ts) mit einem einstellbaren Verhältnis von Einschaltdauer (Te) und Ausschaltdauer (Ta), bei welchem ein quantisiertes Signal (A) in ein pulsweitenmoduliertes Signal (PWM) umgesetzt und als eine diskrete Impulsfolge von Einschaltvorgängen und Ausschaltvorgängen mit der vorgegebenen Schaltperiode (Ts) erzeugt wird, wobei die Schaltflanke für die Einschaltdauer (Te) und/ oder die Ausschaltdauer (Ta) in Abhängigkeit vom Verhältnis von Einschaltdauer (Te) und Ausschaltdauer (Ta) bestimmt wird.

2.  Verfahren nach Anspruch 1, wobei die Schaltflanke der Einschaltdauer (Te) bei einem Verhältnis von Einschaltdauer (Te) zur Ausschaltdauer (Ta) von kleiner 1 am Anfang der Schaltperiode (Ts) gesetzt wird.

3.  Verfahren nach Anspruch 1 oder 2, wobei die Schaltflanke der Ausschaltdauer (Ta) bei einem Verhältnis von Einschaltdauer (Te) zur Ausschaltdauer (Ta) von kleiner 1 am Ende der Schaltperiode (Ts) gesetzt wird.

4.  Verfahren nach einem der Ansprüche 1 bis 3, wobei die Schaltflanke der Einschaltdauer (Te) bei einem Verhältnis von Einschaltdauer (Te) zur Ausschaltdauer (Ta) von größer 1 am Ende der Schaltperiode (Ts) gesetzt wird.

5.  Verfahren nach einem der Ansprüche 1 bis 4, wobei die Schaltflanke der Ausschaltdauer (Ta) bei einem Tastverhältnis von Einschaltdauer (Te) zur Ausschaltdauer (Ta) von größer 1 am Anfang der Schaltperiode (Ts) gesetzt wird.

6. Verfahren nach einem der Ansprüche 1 bis 5, wobei die Zeitdauer der Einschaltdauer (Te) durch die Zeitdauer der Ausschaltdauer (Ta) ersetzt wird oder umgekehrt.

7. Verfahren nach einem der Ansprüche 1 bis 6, wobei die Schaltflanke für die Einschaltdauer (Te) durch Negation der innerhalb der Schaltperiode (Ts) erzeugten Ausschaltvorgänge bestimmt wird.

8. Verfahren nach einem der Ansprüche 1 bis 7, wobei die Schaltflanke für die Ausschaltdauer (Ta) durch Negation der innerhalb der Schaltperiode (Ts) erzeugten Einschaltvorgänge bestimmt wird.

9. Verfahren nach einem der Ansprüche 1 bis 8, wobei bei einer symmetrischen Pulsweitenmodulation innerhalb der konstanten Schaltperiode (Ts) mindestens zwei Einschaltdauern (Te1, Te2) vorgegeben werden, deren Schaltflanken am Anfang und am Ende mindestens einer Schaltperiode (Ts) gesetzt werden.

10. Verfahren nach Anspruch 9, wobei ein der symmetrischen Pulsweitenmodulation zugrunde liegendes Referenzsignal als ein vom Anfang der Schaltperiode (Ts) bis zur Mitte der Schaltperiode (Ts) fallendes und von der Mitte bis zum Ende der Schaltperiode (Ts) steigendes Signal vorgegeben wird.

11. Verfahren nach Anspruch 10, wobei als Referenzsignal eine Zählfunktion (F1) verwendet wird.

12. Vorrichtung (1) zur Pulsweitenmodulation mit einer vorgegebenen Schaltperiode (Ts) mit einem einstellbaren Verhältnis von Einschaltdauer (Te) und Ausschaltdauer (Ta), bei welchem eine Steuereinheit (2) derart ausgebildet ist, dass diese ein quantisiertes Signal in ein pulsweitenmodulierten Signal (PWM) umsetzt und dieses als eine diskrete Impulsfolge von Einschaltvorgängen und Ausschaltvorgängen mit der vorgegebenen Schaltperiode (Ts) erzeugt, wobei die Schaltflanke für die Einschaltdauer (Te) und/ oder die Schaltflanke für die Ausschaltdauer (Ta) in Abhängigkeit vom Verhältnis von Einschaltdauer (Te) und Ausschaltdauer (Ta) bestimmbar ist.

13. Vorrichtung nach Anspruch 12, wobei die Steuereinheit (2) derart ausgebildet ist, dass diese die Schaltflanke der Einschaltdauer (Te) bei einem Verhältnis von Einschaltdauer (Te) zur Ausschaltdauer (Ta) von kleiner 1 am Anfang der Schaltperiode (Ts) setzt.

14. Vorrichtung nach Anspruch 12 oder 13, wobei die Steuereinheit (2) derart ausgebildet ist, dass diese die Schaltflanke der Ausschaltdauer (Ta) bei einem Tastverhältnis von Einschaltdauer (Te) zur Ausschaltdauer (Ta) von kleiner 1 am Ende der Schaltperiode (Ts) setzt.

15. Vorrichtung nach einem der Ansprüche 12 bis 14, wobei die Steuereinheit (2) derart ausgebildet ist, dass diese die Schaltflanke der Einschaltdauer (Te) bei einem Tastverhältnis von Einschaltdauer (Te) zur Ausschaltdauer (Ta) von größer 1 am Ende der Schaltperiode (Ts) setzt.

16. Vorrichtung nach einem der Ansprüche 12 bis 15, wobei die Steuereinheit (2) derart ausgebildet ist, dass diese die Schaltflanke der Ausschaltdauer (Ta) bei einem Tastverhältnis von Einschaltdauer (Te) zur Ausschaltdauer (Ta) von größer 1 am Anfang der Schaltperiode (Ts) setzt.

17. Vorrichtung nach einem der Ansprüche 12 bis 16, wobei die Steuereinheit (2) mindestens ein Negationsmittel (8) umfasst, das die Schaltflanke für die Einschaltdauer (Te) durch Negation der innerhalb der Schaltperiode (Ts) erzeugten Ausschaltvorgänge bestimmt.

18. Vorrichtung nach einem der Ansprüche 12 bis 17, wobei die Zeitdauer der Einschaltdauer (Te) durch die Zeitdauer der Ausschaltdauer (Ta) ersetzbar ist oder umgekehrt.

19. Vorrichtung nach einem der Ansprüche 12 bis 18, wobei die Steuereinheit (2) mindestens ein Negationsmittel (8) umfasst, das die Schaltflanke für die Ausschaltdauer (Ta) durch Negation der innerhalb der Schaltperiode (Ts) erzeugten Einschaltvorgänge bestimmt.

20. Vorrichtung nach einem der Ansprüche 12 bis 19, wobei die Steuereinheit (2) derart ausgebildet ist, dass diese bei einer symmetrischen Pulsweitenmodulation innerhalb der konstanten Schaltperiode (Ts) mindestens zwei Einschaltdauern (Te1, Te2) vorgibt, deren Schaltflanken am Anfang und am Ende mindestens einer oder zweier benachbarter Schaltperioden (Ts) setzt.

EP 1 947 766 A2

# FIG 1
( Stand der Technik )

# FIG 2

# FIG 3

FIG 4A
( Stand der Technik )

PWM

Te

Ts

t

FIG 4B

PWM'

Te'

Ts

t

FIG 4C

$\overline{PWM'}$

Te1

Ta

Te2

Ts

t

T3

Te1=Te2=Te/2

## FIG 5A
( Stand der Technik )

$Te$

PWM

F1

A

$Ts/2$

$Ts$

t

## FIG 5B

$Te1 = Te/2$

$Te2 = Te/2$

PWM

$\overline{A}$

F1

$Ts/2$

$Ts$

t

$T4$

## FIG 6

1

2

G

A

8

8

PWM' oder $\overline{PWM}$

Steuerbit

6

4